# EUROPEAN PATENT SPECIFICATION

(11) **EP 0 274 881 B1**
(45) Date of publication and mention of the grant of the patent: **17.03.1993**
(21) Application number: 87311099.3
(22) Date of filing: 16.12.1987
(51) Int. Cl.: H01L 37/02, G01J 5/20, G01J 5/34

(54) **Thermal detectors and process for manufacturing the same**
Thermische Detektoren und Verfahren zu ihrer Herstellung
Détecteurs thermiques et méthode pour leur fabrication

(30) Priority: 16.12.1986 JP 300259/86; 16.12.1986 JP 300260/86; 29.12.1986 JP 311162/86
(43) Date of publication of application: 20.07.1988
(73) Proprietor: SHIMADZU CORPORATION, Nakagyo-ku Kyoto-shi Kyoto 604 (JP)
(72) Inventor: Oka, Syotaro, Muko 617 (JP); Kita, Junichi, Nishikyo-ku Kyoto 610-11 (JP); Kuyama, Hiroki, Ukyo-ku Kyoto 616 (JP); Kiri, Motosada, Nishikyo-ku Kyoto 610-11 (JP)
(74) Representative: Lawrence, Malcolm Graham

(56) References cited:
- EP-A- 0 089 770
- FR-A- 2 323 133
- FR-A- 2 440 039
- APPLIED OPTICS, vol. 13, no. 5, May 1974, pages 1171-1178; W.R. BLEVIN et al.: "Influence of black coatings on pyroelectric detectors"
- FERROELECTRICS, vol. 69, no. 3/4, July 1986, pages 231-239, Gordon and Breach Science Publishers S.A., London, GB; M.M. PRADHAN et al.: "Pyroelectric detector-modulator and remote transmission"

## Description

This invention relates to thermal detectors. More particularly, it relates to a thermal radiation detector useful for the detection of infrared rays and temperature, such as a pyroelectric infrared sensor, thermopile or thermistor-bolometer. The invention also relates to a process for manufacturing the aforesaid thermal detectors.

Pyroelectric elements detect changes in surface charges caused by the pyroelectric effect resulting from the rise in temperature of the surface due to the thermal energy of incident infrared rays. They find utility as thermal detectors, such as infrared and temperature sensors. Such pyroelectric elements comprise a pyroelectric material and a pair of smooth-surface, membrane electrodes formed on both faces thereof. One of the membrane electrodes is used as a heat-absorbing face. The pyroelectric material may be a ceramic material such as a compound of Sr_{1-X}Ba_{X}Nb₂O₆, Pb₅Ge₃O₁₁, TGS (triglycine sulfate) and its analogues, PbTiO₃, PbTi_{X}Zr_{1-X}O₃ or LiTaO₃, or an organic compound such as PVDF (polyvinylidene fluoride) e.g. M.M. Pradhan et al., "Pyroelectric Detector-Modulator and Remote Transmission", Ferroelectrics, Vol.69, No.314, July 1986, 231-239. Various attempts have been made in order to enhance detection sensitivity. For example, a metal layer of higher heat absorption (eg Cr and Ni-Cr deposited layers) has been used as the heat-absorbing membrane electrode, in place of the conventional Pt and Au deposited layers. A carbon paste layer has been applied to the surface of the conventional Pt or Au deposited layer by coating or a gold black layer applied thereto by vacuum deposition [W.R.Blevin et al., "Influence of Black Coating on Pyroelectric Detectors", Applied Optics, 13, No 5, 1171-1178 (1984)].

These techniques, however, have disadvantages. The use of the Cr or Ni-Cr layer is insufficient in terms of heat absorption efficiency because it still has some reflectivity. The layer of gold back deposited on the surface of a membrane electrode is frequently insufficient in terms of heat absorption efficiency and is low in sensitivity, particularly in long-wavelength regions (10 to 25 µm). The coated layer of carbon paste tends to be thick (it is difficult to achieve a thickness less than 1000 µm) and this means increased thermal capicitance for the thermal detector as a whole.

In addition, the problem common to all of these techniques is the difficulty in forming a layer exactly on the surface of membrane electrode; metal or carbon paste tends to be deposited or coated on areas outside the electrode surface, causing uneveness in sensitivity.

The aim of the invention is to provide thermal detectors excellent in heat absorption efficiency and in detection sensitivity for infrared rays.

It has been found that the heat absorption efficiency and detection sensitivity for long-wavelength rays can be significantly enhanced if the black membrane of previous metal (eg gold black and platinum black) is formed on the membrane electrode by an electrolytic process, not by the vacuum deposition process.

Thus, this invention provides thermal detectors and a process of manufacturing such detectors as set out in the claims.

The thermal detectors of this invention are highly sensitive because of the excellent heat absorption efficiency, and also show little change in sensitivity over a wide wavelength range. In addition, electrodeposition ensures the black membrane layer is deposited exactly on the surface of the membrane electrode, rarely resulting in uneveness in sensitivity. The manufacturing process is also very simple.

The base material of the thermal detectors of the invention may be a pyroelectric, semiconductive or insulating material. When a pyroelectric material is used, for example, the provision of membrane electrodes on both faces thereof gives a pyroelectric thermal detector. Thermistor-bolometers can be prepared in a similar way by using a semiconductor as base material. When an insulating material is used, it is also possible to manufacture thermopiles by providing at least one pair of thermocouple electrodes on one face thereof.

The pyroelectric material may be a ceramic material or organic compound as mentioned hereinbefore in that connection. The use of LiTaO₃, PbTiO₃ and PZT (ie PbO, ZrO₂ and TiO₂, namely a solid solution of lead titanate and lead zirconate) - compounds which are not deliquescent - in the form of plates is preferred; such a pyroelectric element may, for example have a size of 1 mm x 1.2 mm x 8 µm (thickness).

The semiconductive material may be a Si or Ge semiconductor or a so-called thermistor semiconductor such as Fe, Co or Ni oxides. Various types of glass plate may be employed as the insulating material.

The most preferred base material is a pyroelectric substance, for the manufacture of pyroelectric thermal detectors.

Suitable membrane electrodes for use in the invention are deposited or sputtered layers of previous metals, such as Pt and Au, but deposited layers of Cr of Ni-Cr, or thermocouple electrodes, may also be employed. The preferred thickness of these electrode membranes is usually in the range from about 0.1 to about 1.0 µm.

The black membrane of precious metal herein means preferably a precious metal (such as platinum, gold, palladium or iridium) which exists in a finely porous and spongy form and is dark or black in colour. Of various precious metals, platinum black is the most preferred.

The black membrane of precious metal used in the invention is formed by electrodeposition using a membrane electrode, formed on a thermal-detector base material as described above, as the electrode for electrolysis. For example, a membrane of platinum black can be formed by immersing the above-mentioned thermal detector element (with a membrane electrode provided thereupon) and a counter electrode in an electrolyte solution (such as an aqueous solution of a platinic acid, eg. chloroplatinic acids), and applying a voltage so that the membrane electrode is a negative electrode. Similarly, a membrane of gold, palladium or iridium black can be formed by using chloroauric acids, palladium chlorides or iridium chlorides respectively, as electrolyte. The concentration of these precious metal compounds in the solution is usually in the range from 40 to 80 moles. The electrolyte solution may also contain other additives for electrolysis, for example, blackening accelerators such as lead acetate.

A suitable voltage to be applied to a membrane electrode depends on the electrode area, distance between electrodes, concentration of electrolyte, temperature and other factors. However, such voltage usually should be set so that the potential of the membrane electrode will be in the range from about -0.2 to about -0.8 V (vs Ag/AgCl).

The thickness of a deposited black membrane of precious metal can be easily controlled by adjusting electrolysis time and should preferably be in the range from about 2 to about 50 µm.

It has been found that black membranes of precious metal with outstanding characteristics can be formed if the potential of the membrane electrode is initially set at a level in the range from about -0.4 to about -0.7 V (vs Ag/AgCl) and then changed to a level in the range from about -0.2 to about -0.4 V in a later stage (2-step electrolysis). Electrolysis should preferably be continued for 20 to 60 seconds in the first step and for 30 to 60 seconds in the second step. Surface analysis by means of a scanning electron microscope (SEM) has revealed that the black membranes of precious metal obtained by this 2-step electrolysis usually have such a fine surface uneveness that the protruded areas are arranged at pitches of about 2 to about 40 µm and the depth of the recessed areas is in the range from about 3 to about 12 µm. The absorption efficiency for infrared rays (2.5 to 25 µm) is well balanced over the whole wavelength range (high efficiency is also observed in long and short wavelength regions), with the overall absorption efficiency being 90% or more. The thermal capacitance of these black membranes is also very low. It has also been demonstrated that still higher absorption efficiency can be achieved with black membranes where the protruded areas are uniformly arranged at a pitch in the range from about 3 to about 12 µm, preferably about 3 to about 7 µm.

The black membrane of precious metal is electrodeposited on at least one of the membrane electrodes formed on heat-absorbing faces. In the manufacture of a pyroelectric thermal detector, for example, the black membrane is deposited on one of a pair of membrane electrodes formed one on each of two faces, eg the opposed faces, of a pyroelectric element. In such cases, electrolysis is conducted by applying a voltage only upon the electrode to be treated, but the black membrane of precious metal tends to be deposited also on the other electrode to a greater or lesser extent. This adversely affects the sensitivity of the thermal detector and the effective formation of intended black membrane. In order to avoid this, the membrane electrode not to be electrocoated with precious metal black has to be protected with a masking agent, such as paraffin wax, during electrolysis, or alternatively this membrane electrode is formed after the electrodeposition of precious metal. It has been found that the above-mentioned difficulty can be avoided if an inverse voltage is applied during electrolysis to the membrane electrode which is not required to be electrocoated. The preferred inverse voltage is such that the potential at membrane electrode will be in the range from about +1.0 to -0.2 V (vs Ag/AgCl).

The following is a specific description intended to illustrate the invention, by way of example only, reference being made to the accompanying drawings in which:
Figure 1 is a schematic view of a pyroelectric thermal detector of this invention, as prepared in the Examples which follows;
Figures 2, 3 and 6 are schematic views illustrating the manufacturing steps for producing a thermal detector as described in Examples 1, 2 and 3, respectively;
Figure 4 is a graph showing the IR reflection ratio of a thermal detector prepared in Example 3; and
Figure 5 is a graph showing the IR reflection ratio of the comparative thermal detector referred to in Example 3.

### Example 1

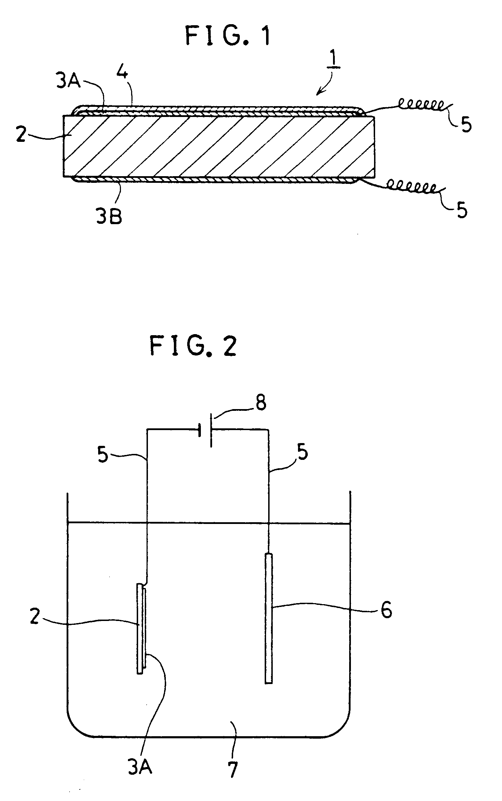

A platinum membrane (membrane electrode), about 0.4 µm in thickness and about 1 mm² in area, was formed by sputtering on one face of a LiTaO₃ pyroelectric element (1.0 x 1.2 x 8 µm), and a gold lead wire was connected to the terminal thereof. This element was immersed in a 57.9 mM aqueous solution of hexachloroplatinic (IV) acid containing 10 mg of lead (II) acetate (electrolyte solution) to form an electrolytic system as shown in Figure 2. In Figure 2, reference numeral 2 designates the pyroelectric element, 3A is the platinum membrane, 6 is a platinum counter electrode (10 x 20 x 1.00 mm), 7 is an electrolyte solution, 8 is a constant-voltage power source, and 5 is a gold lead wire.

Electrolysis at a voltage of 1.30 V over a period of 40 seconds formed a platinum black membrane 4 (Figure 1) about 10 µm thick on one face of the platinum membrane 3A. A membrane electrode was formed by sputtering on the back face in a similar way to that described above, giving the thermal detector 1 of this invention shown in Figure 1.

The heat absorption efficiency of thermal detector 1 was evaluated by measuring the IR reflection ratio at the heat-absorbing area. Measurement was made by means of FT-IR (Fourier-transform IR spectrophotometer) at an incident-light angle of about 60 to 90°. The reflection ratio was calculated from the following equation using the reflected light spectrum from an aluminum mirror as reference: 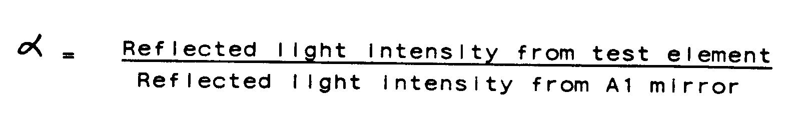
The heat absorption efficiency of the above platimum black membrane for 2.5 to 25 µm infrared rays was found to be about 85%.

### Example 2

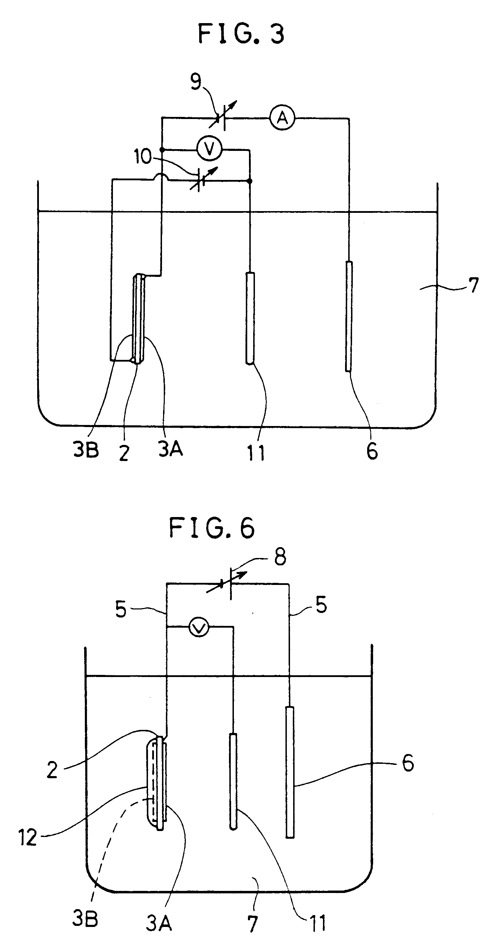

A platinum membrane (membrane electrode), about 0.4 µm in thickness and about 1 mm² in area, was formed by sputtering on both faces of a LiTaO₃ pyroelectric element (1.0 x 1.2 x 8 µm), and a gold lead wire was connected to the terminal thereof. This element was immersed in a 57.9 mM aqueous solution of chloroplatinic acid containing 10 mg of lead acetate (electrolyte solution) to form an electrolytic system as shown in Figure 3. in Figure 3, reference numeral 11 is a reference electrode (Ag/AgCl) for potential monitoring, 9 is a power source to supply electrolytic voltage across platinum membrane 3A and counter electrode 6, and 10 is an inverse voltage power source to supply inverse voltage to platinum membrane 3B (back face).

Electrolysis was continued at room temperature for one minute with no agitation while controlling power sources 9 and 10 so that the potential of platinum membrane 3A will be -0.3 V and that of platinum membrane 3B will be +0.1 V. As a result, thermal detector 1 as shown in Figure 1 was obtained, a uniform platinum black membrane about 10 µm thick having been formed on membrane 3A whilst no platinum black membrane was formed on membrane 3B. The heat absorption efficiency of thermal detector 1 for 2.5 to 25 µm infrared rays was found to be about 90%.

In contrast, when electrolysis was conducted by the conventional method with no inverse voltage applied to platinum membrane 3B, non-uniform formation of platinum black was observed on membrane 3B and the uniformity of formation of platinum black membrane deposited on membrane 3A was unsatisfactory.

### Example 3

3 g hexachloroplatinic (VI) acid (H₂PtCl₆ 6H₂O) was mixed with about 10 mg of lead (II) acetate. The mixture was dissolved in water to make up 100 ml, and the resulting solution was used as electrolyte solution. Electrolysis was conducted as shown in Figure 6 using, as working electrode, one face of a LiTaO₃ pyroelectric element 2 (both faces of which had been coated with platinum to form a membrane electrode, as in Example 2), the back face of element 2 being protected with paraffin wax 12 (Apiezone Wax; a product of Nikka Seiko Co Ltd). Platinum was used as counter electrode 6 and an Ag/AgCl electrode was employed as reference electrode 11. Electrolysis was carried out in two steps: (1) at room temperature for 20 seconds with the potential of working electrode set at -0.4 V; and (2) for 40 seconds with the potential maintained at -0.2 V. The thickness of platinum black membrane formed on the working electrode was 12 to 17 µm. SEM analysis showed that it has a fine surface uneveness uniformly spread over the entire area, with the protruded portions being arranged at pitches of 3 to 7 µm and the depth of the recessed portions being 3 to 12 µm. Such a surface uneveness is supposed to cause irregular reflection of electromagnetic waves in the infrared region, thus making a black surface, and to ensure highly efficient thermal absorption.

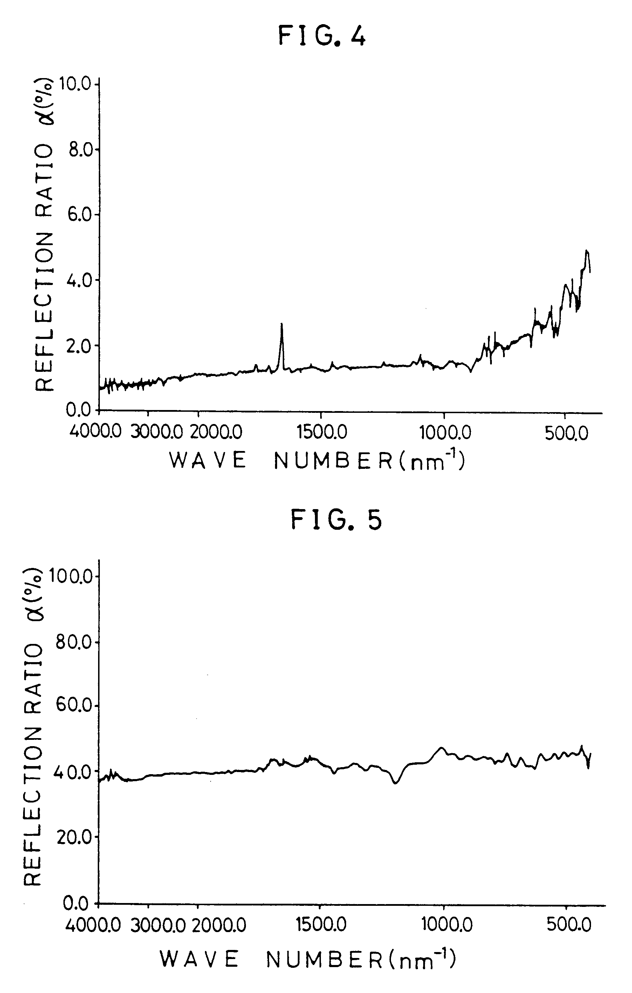

The IR reflection ratio of this platinum black membrane was measured in the same manner as in Example 1. The result obtained is shown in Figure 4. As can be estimated from the figure, the overall heat absorption efficiency was 95%, with the value for 2.5 µm infrared rays amounting to about 99%. For comparison, the data for a commercial thermal detector, comprising DLATGS (L-alanine doped TGS) with a Cr membrane coated thereupon as membrane electrode, is shown in Figure 5. The heat absorption efficiency of this commercial detector was about 64%. This clearly shows that the thermal detector of this Example has high IR absorption efficiency over a wide infrared range and hence provides an infrared detector and thermo-sensor with high S/N ratio and sensitivity.

## Claims

1. A thermal detector comprising at least one pair of membrane electrodes (3A, 3B) formed on a base material (2), wherein at least one member of said pair of electrodes has a coating of a black membrane (4) of precious metal, said black membrane (4) having a surface comprising raised areas pitched apart from about 2 to about 40 µm and recessed areas from about 3 to about 12 µm in depth.

2. A thermal detector as claimed in claim 1, wherein the protruded areas are uniformly arranged at a pitch in the range from about 3 to about 7 um.

3. A thermal detector as claimed in claim 1 or claim 2, wherein the base material (2) is made of a pyroelectric, semiconductive or insulating material.

4. A thermal detector as claimed in claim 3, wherein the base material (2) is made of a pyroelectric material selected from ceramic materials and organic compounds.

5. A thermal detector as claimed in claim 4, wherein the ceramic material is a compound of the formula Sr_{1-X} Ba_{X}Nb₂O₆, Pb₅Ge₃O₁₁, triglycine sulfate (TGS) or an analogue thereof, PbTIO₃, PbTI_{X}Zr_{1-X}O₃ or LiTₐO₃.

6. A thermal detector as claimed in claim 4, wherein the organic compound is PVDF (polyvinylidene fluoride).

7. A thermal detector as claimed in any preceding claim, wherein the black membrane (4) of precious metal is gold black, platinum black, palladium black or iridium black.

8. A thermal detector as claimed in any preceding claim, wherein the thickness of the black membrane (4) of precious metal is in the range from 2 to 50µm.

9. A thermal detector as claimed in any preceding claim, wherein the membrane electrodes (3A, 3B) are films of gold, platinum, chromium or nickel-chromium.

10. A thermal detector as claimed in any preceding claim, wherein the thickness of the membrane electrodes (3A, 3B) is in the range from 0.1 to 1µm.

11. A process of manufacturing thermal detectors as claimed in any preceding claim, which process comprises contacting with an electrolyte solution (7) an element comprising a base material (2) and a pair of membrane electrodes (3A, 3B) formed thereupon, and electrolytically depositing a black membrane (4) of precious metal onto the surface of one of the membrane electrodes (3A, 3B) by applying a voltage to that membrane electrode (3A) and an inverse voltage to the other membrane electrode (3B) not to be electrocoated, the potential of the membrane electrode (3A) to be electrocoated being set at a level in the range from -0.2 to -0.8 V vs. Ag/AgCl and the potential of the other membrane electrode (3B) not to be electrocoated being set at a level in the range from +1 to about -0.2 V vs. Ag/AgCl.

12. A process as claimed in claim 11, wherein the potential of the membrane electrode (3A) to be electrocoated is initially set at a value in the range from about -0.4 to -0.7 V vs.Ag/AgCl and changed during electrolytic deposition to a value in the range from about -0.2 to -0.4 V vs.Ag/AgCl.

## Patentansprüche

1. Thermischer Detektor, der mindestens ein Paar Membranelektroden (3A, 3B) enthält, die auf einem Grundmaterial (2) ausgebildet sind, wobei mindestens eine Elektrode des Elektrodenpaares einen Überzug aus einer schwarzen Membran (4) aus Edelmetall aufweist, und wobei die schwarze Membran (4) eine Oberfläche aufweist, die angehobene Bereiche, die in einer Entfernung von ungefähr 2 bis ungefähr 40 µm voneinander aufgerichtet sind, und abgesenkte Bereiche enthält, die eine Tiefe von ungefähr 3 bis ungefähr 12 µm aufweisen.

2. Thermischer Detektor nach Anspruch 1, wobei die vorstehenden Bereiche einheitlich in einem Abstand im Bereich von ungefähr 3 bis ungefähr 7 µm angeordnet sind.

3. Thermischer Detektor nach Anspruch 1 oder 2, wobei das Grundmaterial (2) aus pyroelektrischem, halbleitendem oder nichtleitendem Material besteht.

4. Thermischer Detektor nach Anspruch 3, wobei das Grundmaterial (2) aus einem pyroelektrischen Material besteht das aus keramischen Materialien und organischen Bestandteilen gewählt wurde.

5. Thermischer Detektor nach Anspruch 4, wobei das keramische Material ein Bestandteil mit der Formel Sr_{1-X} Ba_{X} Nb₂O₆, Pb₅Ge₃O₁₁, Triglycerinsulfat (TGS) oder ein Analog davon, PbTIO₃, PSTI_{X}Zr₁-_{X}O₃ oder LiTₐO₃ ist.

6. Thermischer Detektor nach Anspruch 4, wobei der organische Bestandteil PVDF (Polyvinylidenfluorid) ist.

7. Thermischer Detektor nach einem oder mehreren der vorhergehenden Ansprüche, wobei die schwarze Membran (4) aus Edelmetall Schwarzgold, schwarzes Platin, schwarzes Palladium oder schwarzes Iridium ist.

8. Thermischer Detektor nach einem oder mehreren der vorhergehenden Ansprüche, wobei die Dicke der schwarzen Membran (4) aus Edelmetall zwischen 2 und 50 µm liegt.

9. Thermischer Detektor nach einem oder mehreren der vorhergehenden Ansprüche, wobei die Membranelektroden (3A, 3B) eine dünne Schicht aus Gold, Platin, Chrom oder Nickel-Chrom sind.

10. Thermischer Detektor nach einem oder mehreren der vorhergehenden Ansprüche, wobei die Dicke der Membranelektroden (3A, 3B) zwischen 0,1 und 1 µm liegt.

11. Verfahren zur Herstellung thermischer Detektoren nach einem oder mehreren der vorhergehenden Ansprüche, wobei das Verfahren das Zusammenbringen einer Elektrolytlösung (7) mit einem Element enthält, das Grundmaterial (2) und ein Paar von Membranelektroden (3A, 3B), die darauf ausgebildet sind, aufweist und wobei elektrolytisch eine schwarze Membran (4) aus Edelmetall auf die Oberfläche einer der Membranelektroden (3A, 3B) aufgebracht wird, indem an diese Membranelektrode (3A) ein Potential angelegt wird und ein entgegengerichtetes Potential an die andere Membranelektrode (3B), die nicht elektrochemisch bedeckt werden soll, angelegt wird, wobei das Potential der Membranelektrode (3A), die elekrochermisch bedeckt werden soll, auf einen Wert im Bereich von -0,2 bis -0,8 V gegen Ag/AgCl eingestellt wird und das Potential der anderen Membranelektrode (3B), die nicht elektrochemisch bedeckt werden soll, auf einen Wert im Bereich von +1 bis ungefähr -0,2 V gegen Ag/AgCl eingestellt wird.

12. Verfahren nach Anspruch 11, wobei das Potential der Membranelektrode (3A), die elektrochemisch bedeckt werden soll, anfänglich auf einen Wert im Bereich von ungefähr -0,4 bis -0.7 V gegen Ag/AgCl eingestellt wird und während der elektrolytischen Ablagerung zu einem Wert im Bereich von ungefähr -0,2 bis 0,4 V gegen Ag/AgCl wechselt.

## Revendications

1. Détecteur thermique comprenant au moins une paire d'électrodes sous forme de membrane (3A, 3B) formées sur un matériau support (2), dans lequel au moins l'un des membres de ladite paire d'électrodes a un revêtement formé d'une couche noire (4) en un métal précieux, ladite couche noire (4) ayant une surface comprenant des zones surélevées en saillie d'environ 2 à environ 40µm et des zones en creux en retrait d'environ 3 à environ 12 µm.

2. Détecteur thermique selon la revendication 1, dans lequel les zones surélevées sont réparties uniformément en saillie dans une plage d'environ 3 à environ 7 µm.

3. Détecteur thermique selon la revendication 1 ou la revendication 2, dans lequel le matériau support (2) est composé d'un matériau pyroélectrique, semiconducteur ou isolant.

4. Détecteur thermique selon la revendication 3, dans lequel le matériau support (2) est composé d'un matériau pyroélectrique choisi parmi les matières céramiques et les composés organiques.

5. Détecteur thermique selon la revendication 4, dans lequel le matériau céramique est un composé de formule Sr_{1-X} Ba_{X}Nb₂O₆, Pb₅Ge₃O₁₁, sulfate de triglycine (TGS), ou un de ses analogues, PbTiO₃, PbTi_{X}Zr_{1-X}O₃ ou LiTaO₃.

6. Détecteur thermique selon la revendication 4, dans lequel le composé organique est le PVDF (fluorure de polyvinylidène).

7. Détecteur thermique selon la revendication 4, dans lequel la couche noire (4) de métal précieux est une couche de noir colloïdal d'or, de platine, de palladium ou d'iridium.

8. Détecteur thermique selon l'une quelconque des revendications précédentes, dans lequel l'épaisseur de la couche noire (4) de métal précieux est dans la plage de 2 à 50 µm.

9. Détecteur thermique selon l'une quelconque des revendications précédentes, dans lequel les électrodes sous forme de membrane (3A, 3B) sont des films d'or, de platine, de chrome ou de nickel-chrome.

10. Détecteur thermique selon l'une quelconque des revendications précédentes, dans lequel l'épaisseur des électrodes sous forme de membrane (3A, 3B) est dans la plage de 0,1 à 1 µm.

11. Procédé de fabrication de détecteurs thermiques tels que revendiqués dans l'une quelconque des revendications précédentes, comprenant la mise en contact avec une solution électrolytique (7) d'un élément comprenant un matériau support (2) et une paire d'électrodes sous forme de membrane (3A, 3B) disposées sur celui-ci, et l'électrodéposition d'une couche noire (4) d'un métal précieux à la surface de l'une des électrodes sous forme de membrane (3A, 3B) par application d'une tension à cette électrode sous forme de membrane (3A) et une tension inverse à l'autre électrode sous forme de membrane (3B) qui n'est pas à revêtir par électrolyse, le potentiel de l'électrode sous forme de membrane (3A) qui est à revêtir par électrolyse étant porté à un niveau dans la plage de -0,2 à -0,8 V par rapport à Ag/AgCl, et le potentiel de l'autre électrode sous forme de membrane (3B) qui n'est pas à revêtir par électrolyse étant porté à un niveau dans la plage de +1 à environ -0,2 V par rapport à Ag/AgCl.

12. Procédé selon la revendication 11, dans lequel le potentiel de l'électrode sous forme de membrane (3A) à revêtir par électrolyse est porté initialement à une valeur dans la plage d'environ -0,4 à -0,7 V par rapport à Ag/AgCl et modifié au cours de l'électrodéposition jusqu'à une valeur dans la plage d'environ -0,2 à - 0,4 V par rapport à Ag/AgCl.
